# EUROPEAN PATENT APPLICATION

(11) **EP 4 145 535 A1**
(43) Date of publication of application: **08.03.2023**
(21) Application number: 21796718.1
(22) Date of filing: 29.03.2021
(51) Int. Cl.: H01L 29/872, H01L 21/20, H01L 21/205, H01L 21/3065, H01L 21/329, H01L 29/06, H01L 29/47, H01L 29/861, H01L 29/868

(54) **METHOD FOR PRODUCING SEMICONDUCTOR ELEMENT, AND SEMICONDUCTOR DEVICE**

(30) Priority: 27.04.2020 JP 2020078653
(71) Applicant: Kyocera Corporation, Kyoto-shi Kyoto 612-8501 (JP)
(72) Inventor: AZUMA, Katsunori, Kyoto-shi, Kyoto 612-8501 (JP); SAWADA, Tatsuro, Kyoto-shi, Kyoto 612-8501 (JP)
(74) Representative: Viering, Jentschura & Partner mbB Patent- und Rechtsanwälte
(86) International application number: PCT/JP2021/013169
(87) International publication number: WO 2021/220690

(57) **Abstract**

A manufacturing method for a semiconductor element includes providing a mask (21) including an opening (22) on a surface (1 1a) of a substrate (11) while leaving a step difference (23) in the mask (21) at an upper surface region around the opening (22), epitaxially growing a semiconductor from the surface (11a) exposed through the opening (22) to over the upper surface region around the opening (22), to produce a semiconductor element including a semiconductor layer (31) including a first surface to which the step difference (23) is transferred, and dry-etching the first surface of the semiconductor layer (31) to transfer the step difference (23), the first surface being a contact surface with the mask (21) before the dry etching is performed. The mask (21) contains an element that serves as a donor or an acceptor in the semiconductor layer (31).

## Description

### TECHNICAL FIELD

The present disclosure relates to a manufacturing method for a semiconductor element, and a semiconductor device.

### BACKGROUND OF INVENTION

A manufacturing method for a semiconductor element in which a Gan-based semiconductor is produced by an epitaxial lateral overgrowth (ELO) method using a mask made of SiO₂, is described in Patent Document 1.

### CITATION LIST

### PATENT LITERATURE

Patent Document 1: JP 4638958 B

### SUMMARY

In one aspect, a manufacturing method for a semiconductor element includes providing a mask including an opening on a surface of a substrate while leaving a step difference in the mask at an upper surface region around the opening, epitaxially growing a semiconductor from the surface exposed through the opening to over the upper surface region around the opening, to produce a semiconductor element including a semiconductor layer, the semiconductor layer including a first surface to which the step difference is transferred, and dry-etching the first surface of the semiconductor layer to transfer the step difference, the first surface being a contact surface with the mask before the dry etching is performed. The mask contains an element that serves as a donor or an acceptor in the semiconductor layer.

In one aspect, a semiconductor device includes a semiconductor element manufactured by the above-described manufacturing method for the semiconductor element.

### BRIEF DESCRIPTION OF THE DRAWINGS

FIG. 1 is a cross-sectional schematic view for describing a manufacturing method for a semiconductor element and the semiconductor element according to an embodiment.
FIG. 2 is a cross-sectional schematic view for describing the manufacturing method for the semiconductor element and the semiconductor element according to the embodiment.
FIG. 3 is a schematic perspective view for describing the manufacturing method for the semiconductor element and the semiconductor element according to the embodiment.
FIG. 4 is a flowchart for describing the manufacturing method for the semiconductor element according to the embodiment.
FIG. 5 is a cross-sectional schematic view for describing the manufacturing method for the semiconductor element according to the embodiment.
FIG. 6 is a flowchart for describing a manufacturing method for a semiconductor device according to an embodiment.

### DESCRIPTION OF EMBODIMENTS

In a manufacturing method using the conventional ELO technique, auto-doping in which Si in a mask enters a crystal may occur. Si serves as an n-type doping material in a GaN-based semiconductor. Thus, a low doping concentration in the order of not more than 10¹⁶/cm³ is difficult to be achieved. This makes it difficult to use a surface side of a semiconductor layer being a contact surface with the mask during epitaxial growth as a high-voltage side. Hereinafter, in the present disclosure, a manufacturing method for a semiconductor element and a semiconductor device will be described. In the manufacturing method and the semiconductor device, a surface side of a semiconductor layer that is in contact with a mask during epitaxial growth is used as a high-voltage side.

A semiconductor element 1, a semiconductor device 2, and a manufacturing method for the semiconductor element 1 according to an embodiment will be described below.

### Embodiment

A manufacturing method for a semiconductor element, the semiconductor element, and a semiconductor device according to the embodiment will be described.

### Manufacturing Method

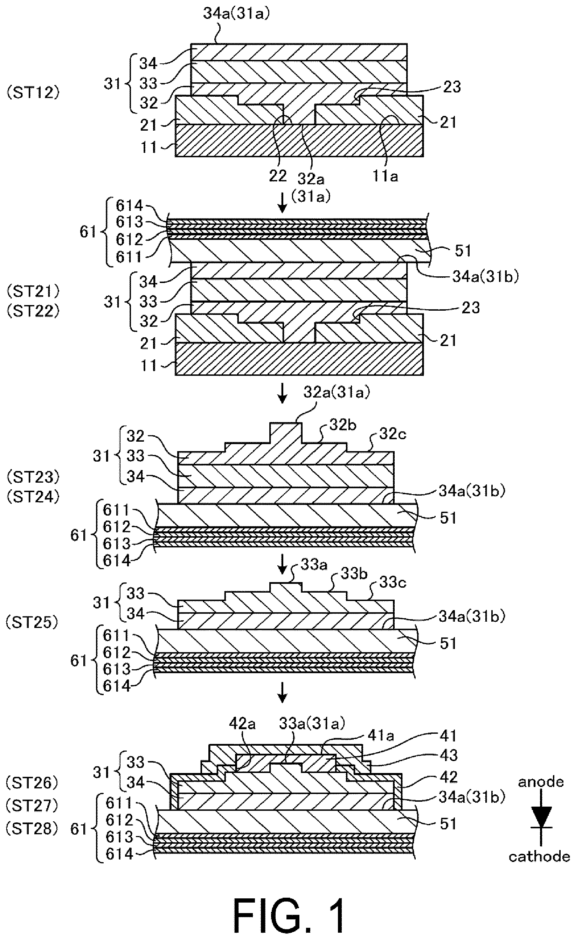

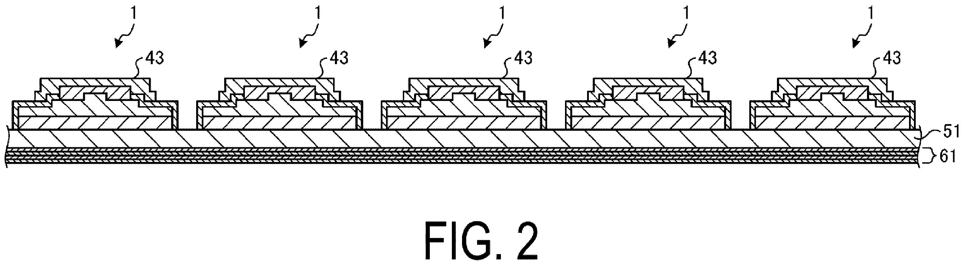

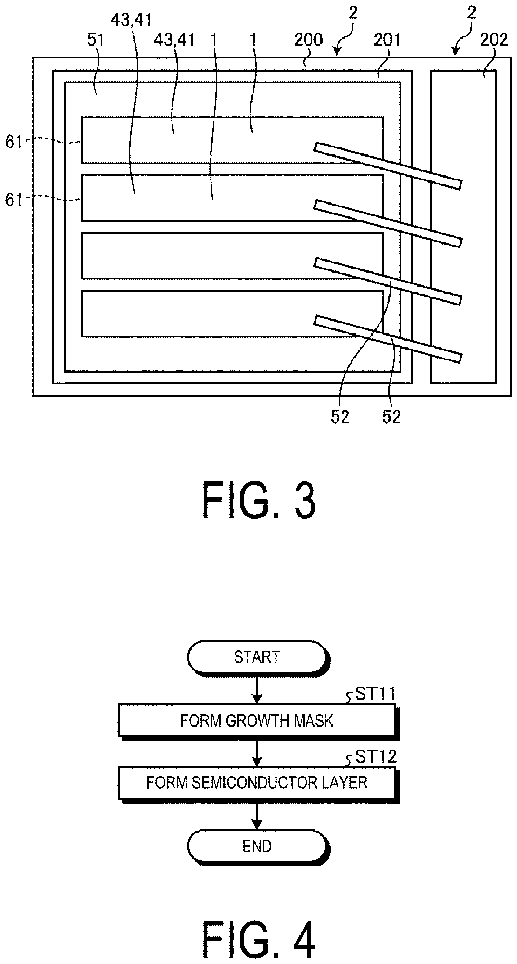

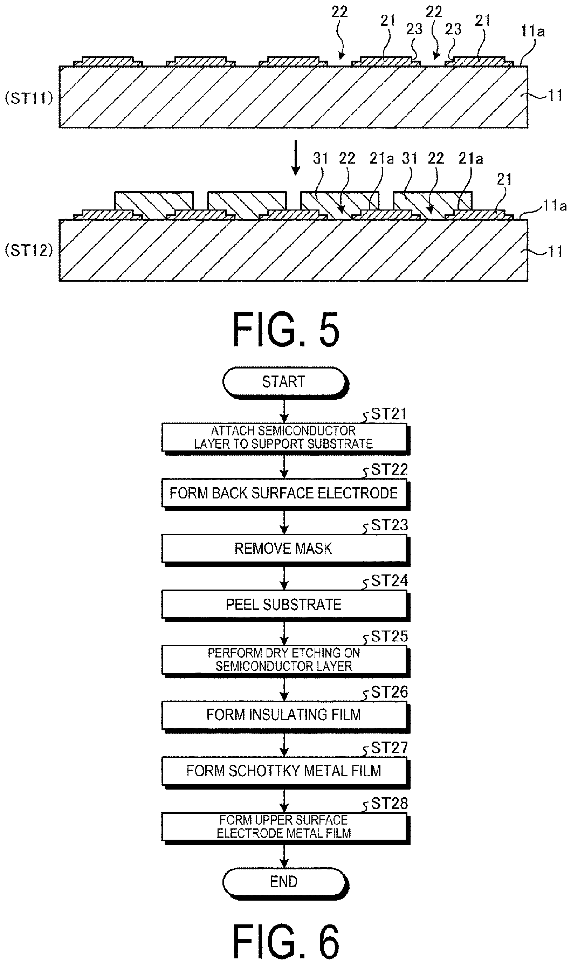

FIG. 1 is a cross-sectional schematic view for describing the manufacturing method for the semiconductor element and the semiconductor element according to the embodiment. FIG. 2 is a cross-sectional schematic view for describing the manufacturing method for the semiconductor element and the semiconductor element according to the embodiment. FIG. 3 is a schematic perspective view for describing the manufacturing method for the semiconductor element and the semiconductor element according to the embodiment. FIG. 4 is a flowchart for describing the manufacturing method for the semiconductor element according to the embodiment. FIG. 5 is a cross-sectional schematic view for describing the manufacturing method for the semiconductor element according to the embodiment. FIG. 6 is a flowchart for describing a manufacturing method for the semiconductor device according to an embodiment.

As illustrated in FIG. 1 to FIG. 3, in the semiconductor element 1 manufactured by the manufacturing method according to the embodiment, a first surface of a semiconductor layer 31 to which a step difference 23 of a mask 21 is transferred is dry-etched, and a shape of the step difference is transferred to the semiconductor layer 31 after the dry etching. The semiconductor device 2 includes the semiconductor element 1 manufactured in this manner. The manufacturing method for the semiconductor element 1 is performed in accordance with a process illustrated in FIG. 4.

First, the mask 21 made of SiO₂ is formed on a surface 11a of a GaN layer, which is a surface layer of a substrate 11 illustrated in FIG. 5 (step ST11). More specifically, the mask 21 including an opening 22 on the surface 11a of the substrate 11 is provided so as to leave the step difference 23 in the mask 21 at an upper surface region around the opening 22. Note that a substrate made of a material other than GaN, such as a silicon substrate (not illustrated), may support the GaN layer, which is the surface layer of the substrate, at a back surface opposite to the surface 11a of the GaN layer. The substrate supporting the back surface of the GaN layer, which is the surface layer of the substrate 11, may be, for example, a sapphire substrate or a silicon carbide (SiC) substrate. The mask 21 contains an element that serves as a donor or an acceptor in the semiconductor layer 31. Examples of a material of the mask 21 may include SiN, AlN, Al₂O₃, and Ga₂O₃. The mask 21 may be amorphous.

The mask 21 includes the opening 22. In the present embodiment, region selection is performed on the upper surface region around the opening 22 by using the shape. The region selection separates the region into an upper region and a lower region of the step difference 23 by using the shape including the step difference 23. The step difference 23 is formed surrounding the periphery of the opening 22. The step difference 23 is formed with a lower step positioned on the opening 22 side and an upper step positioned in a region away from the opening 22. A boundary line between the regions divided by the region selection surrounds the opening 22. Such a shape having the step difference 23 is formed by a well-known photolithography technique, dry etching, wet etching, or the like.

A portion of the surface 11a of the substrate 11 corresponding to the opening 22 of the mask 21 is exposed. For step ST11 in FIG. 5, a diagram is illustrated in which the mask 21 does not cover the surface 11a positioned at both ends of the substrate 11. However, the mask 21 may cover the surface 11a positioned at both the ends of the substrate 11. The mask 21 may cover the entire side surface or back surface of the substrate 11. The mask 21 may cover the entirety excluding the opening 22, of the surfaces that may come into contact with a raw material gas used in a vapor deposition technique, which will be described below.

As illustrated in FIG. 1 and FIG. 5, the GaN layer is formed as the semiconductor layer 31 from the surface 11a of the substrate 11 exposed through the opening 22 by using the ELO technique described above (step ST12). More specifically, a semiconductor is epitaxially grown from the surface 11a exposed through the opening 22 to over the upper surface region around the opening 22, to produce the semiconductor element 1 including the semiconductor layer 31 including a first surface to which the step difference 23 is transferred. Specifically, by using the ELO technique, an epitaxial apparatus (not illustrated) epitaxially grows GaN from the surface 1 1a of the substrate 11 exposed through the opening 22 to over the upper surface region around the opening 22 to epitaxially grow a GaN layer 32 with a high impurity concentration. In step ST12, the GaN layer 32 is grown to over the upper surface region around the opening 22, which is subjected to the region selection. Thus, the GaN layer 32 expands to different regions subjected to the region selection. In the present embodiment, the different regions subjected to the region selection mean the lower step and the upper step with respect to the step difference 23. Thus, the GaN layer 32 expands not only to the lower step, but also to the upper step. As a result, the shape of the step difference 23 is transferred to the lower surface of the GaN layer 32, which is the first surface of the semiconductor layer 31. The first surface of the semiconductor layer 31 is a surface that has come into contact with the mask 21 during the epitaxial growth. In this way, in the present embodiment, an effect of the region selection is the transfer of the shape to the semiconductor layer 31.

The GaN layer 32 may be auto-doped with impurities from the material included in the mask 21 during crystal growth. The GaN layer 32 may be auto-doped with the impurities at up to about 10¹⁹ cm⁻³. When the impurities are Si (Silicon), the GaN layer 32 becomes an n+ semiconductor doped at a high concentration. The GaN layer 32 is first vertically grown from the surface 11a exposed through the opening 22 and then horizontally grown so as to fill the step difference 23. Thus, the surface of the GaN layer 32 becomes substantially flat.

In order to obtain a desired impurity concentration profile, a GaN layer 33 with a low impurity concentration is epitaxially grown to cover the GaN layer 32. The GaN layer 33 is an n- semiconductor layer. A doping amount of n-type impurities is controlled so that the GaN layer 33 has an electron carrier concentration of lower than 10¹⁷ cm⁻³. The GaN layer 33 is not in contact with the mask 21 during the epitaxial growth, so that the auto-doping is reduced. The GaN layer 32 covers a large portion of the mask 21, so that the auto-doping of the GaN layer 33 is also reduced.

The GaN layer 33 can serve as a high voltage layer in which a depletion layer spreads when a voltage is applied during a device operation. In order to serve as a high voltage layer when a high voltage is applied to a power device, the GaN layer 33, for example, in an element to which a voltage of equal to or higher than 600 V is applied may have an electron carrier concentration of lower than 10¹⁶ cm⁻³.

A GaN layer 34 with a high impurity concentration is epitaxially grown so as to cover the GaN layer 33. The GaN layer 34 is an n+ semiconductor layer. A doping amount of n-type impurity is controlled so that the GaN layer 34 has an electron carrier concentration of equal to or higher than 10²⁰ cm⁻³. This layer with the high concentration has a low electrical resistance and can reduce an electrical resistance of a junction portion with an electrode metal that is to be attached in a subsequent step.

As described above, the semiconductor element 1 including the GaN layer 32 of the semiconductor layer 31 in which the effect of the region selection remains on the upper surface of the mask 21, in other words, the GaN layer 32 of the semiconductor layer 31 to which the shape of the step difference 23 has been transferred is produced as illustrated in FIG. 1. The semiconductor layer 31 is formed on the substrate 11. The semiconductor layer 31 is epitaxially grown in a layering direction of the GaN layer 32 serving as an n+ type semiconductor layer, the GaN layer 33 serving as an n- type semiconductor layer, and the GaN layer 34 serving as an n+ type semiconductor layer from the surface.

A manufacturing method for the semiconductor device 2 including the semiconductor element 1 will be described with reference to FIG. 1 and FIG. 6. Step ST21 to step ST27 are performed after performing step ST11 and step ST12.

The semiconductor layer 31 of the semiconductor element 1 is adhered to a support substrate 51 (step ST21). More specifically, an upper surface 34a of the GaN layer 34, which is a back surface 31b of the semiconductor layer 31 on the opposite side to the substrate 11, is joined to the support substrate 51. As the joining, joining with metal interposed or direct joining may be used to reduce the electrical resistance of connection.

A back surface electrode 61 is formed on the support substrate 51 (step ST22). More specifically, the back surface electrode 61 is formed by, for example, sputtering or the like on the upper surface of the support substrate 51. The back surface electrode 61 is obtained by, for example, performing Ti/Ni/Au plating on an Al layer. Note that the back surface electrode 61 may be formed after an upper surface electrode metal film 43, which will be described below, is formed. In the manufacturing method including a step of increasing a temperature, for example, performing step ST22 last can avoid the influence of the step on the back surface electrode 61.

Alternatively, the support substrate 51 including the back surface electrode 61 in advance may be used. The support substrate 51 may be a semiconductor having a high impurity concentration to have a low electrical resistance.

The mask 21 is removed (step ST23). More specifically, the mask 21 is dissolved by wet etching.

The semiconductor layer 31 is peeled from the substrate 11 while the upper surface 34a of the GaN layer 34, which is the back surface 31b of the semiconductor layer 31, is joined to the support substrate 51 (step S24). More specifically, the semiconductor layer 31 is peeled from the substrate 11 by cracking crystals near the opening 22 with an ultrasonic wave or the like. FIG. 1 illustrates a state in which the upper side and the lower side are inverted after the peeling. The shape of the step difference 23 is transferred to the lower surface of the GaN layer 32. More specifically, as illustrated in FIG. 1, a step 32b, which is lower by one step than a surface 32a of the semiconductor layer 31 separated from the substrate 11, is formed around the surface 32a. A step 32c, which is lower by one step than the step 32b, is formed around the step 32b.

FIG. 1 and the like illustrate all the step differences larger for the explanation. A step difference between the surface 32a and the surface 32b may be equal to or less than 0.5 µm, or may be approximately 0.1 µm. A step difference between the surface 32b and the surface 32c may be approximately equal to or more than 0.5 µm and equal to or less than 10 µm.

The GaN layer 32 is dry-etched (step ST25). More specifically, dry etching is performed on the lower surface of the GaN layer 32, which is the first surface of the semiconductor layer 31 and is in contact with the mask 21 before the dry etching is performed, to transfer the step difference 23. Specifically, the GaN layer 32 is dissolved by at least either dry etching or wet etching. In this way, step differences of the GaN layer 32 are transferred to form a step 33b, which is lower by one step than a surface 33a of the GaN layer 33, around the surface 33a, and a step 33c, which is lower by one step than the step 33b, around the step 33b. The GaN layer 33 is formed so as to have a mesa structure or a trench structure by transferring the step differences. In the present embodiment, a case where a step difference 33b-33c is used as the mesa structure is illustrated as an example.

Specifically, the GaN layer 32 may be removed by one dry etching. An inductively coupled plasma reactive ion etching (ICP-RIE) apparatus is employed for the dry etching. The etching by the dry etching removes a damage layer introduced to the GaN layer 32. The lower surface of the GaN layer 32, which is the first surface of the semiconductor layer 31, is dry-etched without a mask.

Note that the GaN layer 32 may be removed by performing dry etching two or more times. In other words, after the dry etching, further dry etching may be performed. As a method of transferring a shape, photo-electro-chemical (PEC) etching may be used.

After the dry etching, wet etching may be performed to remove the GaN layer 32. Specifically, after the dry etching performed in the above-described manner, wet etching is performed to remove the damage layer. The use of a tetramethylammonium hydroxide solution as an etching solution allows anisotropic etching, and the damage layer can be removed while the shape of the transferred step differences is retained. After the dry etching, the wet etching is performed, so that the damage layer can be removed.

An insulating film 42, which includes an opening surrounding the surface 33a and covers the mesa structure (32b-32c), is formed (step ST26).

Forming the mesa step difference can relax an electric field applied to an electrode end portion. Thus, a high voltage element can be produced.

A Schottky metal film 41, which forms a Schottky junction with the GaN layer 33 exposed through the opening of the insulating film 42, is formed (step ST27). The Schottky metal film 41 covers the opening of the insulating film 42.

The upper surface electrode metal film 43 is formed so as to extend, on the Schottky metal film 41 and on the insulating film 42, to the mesa structure (33b-33c) (step S28). The upper surface electrode metal film 43 forms a so-called field plate on the insulating film 42.

Forming the field plate can further relax the electric field applied to the electrode end portion. Thus, a high voltage device with can be obtained.

In the above-described manner, the semiconductor element 1 is manufactured. Here, the semiconductor element 1 is a Schottky barrier diode.

The mesa structure is formed in the semiconductor layer 31 of the semiconductor element 1 by transferring the shape of the step difference 23 of the mask 21 as described above.

Note that, regardless of the above-described embodiment, the shape may have two or more step differences. The step difference is not limited to a step difference that goes upward from the opening 22 toward an outer side in a radial direction, and a step difference that goes downward can be adopted. Thus, forming a shape that goes upward and then goes downward can also form a shape having a protrusion. Transferring the shape having the protrusion of the mask 21 can also form a trench structure. Thus, instead of the mesa structure described above, the trench structure may be employed. One or more trench structures and a mesa structure at an outer edge can be formed from the center of the semiconductor element 1 toward the outer side in the radial direction.

The shape of the step difference 23 may have an inclination or may have rounded corners.

The manufacturing processes described above are performed concurrently in parallel so as to simultaneously manufacture a plurality of semiconductor elements 1 as illustrated in FIG. 2. In other words, a plurality of openings 22 are formed in the mask 21, and the plurality of semiconductor elements 1 are simultaneously produced such that one semiconductor element 1 corresponds to one opening 22.

The semiconductor elements 1 may be separated from each other to form the semiconductor device 2. When the capacity needs to be increased, for example, while the plurality of semiconductor elements 1 share the support substrate 51 and the back surface electrode 61 as illustrated in FIG. 2, the plurality of semiconductor elements 1 may be mounted as illustrated in FIG. 3 to be used for the semiconductor device 2. Specifically, as illustrated in FIG. 3, the common back surface electrode 61 is die-bonded to one electrode pad 201 on a mounting substrate 200, and individual upper surface electrode metal films 43 are connected to the other electrode pad 202 by using bonding wires 52. By mounting the mounting substrate 200 in this manner, a plurality of diodes can be connected in parallel to increase the capacity, to be used. At this time, the plurality of semiconductor elements 1 are manufactured so as to be aligned and disposed in a certain direction. In a plan view, the semiconductor elements 1 each have a shape elongated in a substantially orthogonal direction with respect to a direction in which the semiconductor elements 1 are aligned. Aligning the semiconductor elements 1 having such a shape in this manner can increase a junction area of the diode. The semiconductor elements 1 manufactured in this manner are available for a variety of semiconductor devices 2 according to applications.

According to the above, the occurrence of auto-doping can be reduced when the semiconductor elements 1 are produced by the ELO method using the mask 21 including an element that serves as a donor or an acceptor in the semiconductor layer 31, for example. By removing, by dry etching, the first surface of the GaN layer 32 of the semiconductor layer 31 that is a contact surface with the mask 21 before the dry etching is performed, the GaN layer 32 including a donor or an acceptor, in other words, the GaN layer 32 affected by the auto-doping, can be removed. In this way, according to the present embodiment, the semiconductor element 1 to which the step difference 23 of the mask 21 is transferred, the semiconductor element 1 having a low doping concentration, can be manufactured. In the present embodiment, the surface side of the semiconductor layer 31 that comes into contact with the mask 21 during the epitaxial growth can be used as the high-voltage side of the semiconductor element 1.

According to the present embodiment, the semiconductor element 1 in which a mesa structure or a trench structure is formed by transferring the step difference 23 of the mask 21 can be manufactured.

In the present embodiment, the first surface of the semiconductor layer 31 can be dry-etched without a mask.

In the present embodiment, the first surface of the semiconductor layer 31 is dry-etched and then wet-etched. According to the present embodiment, the damage layer of the semiconductor layer 31 can be more appropriately removed.

In the present embodiment, the first surface of the semiconductor layer 31 is dry-etched and then further dry-etched. According to the present embodiment, the damage layer of the semiconductor layer 31 can be more appropriately removed.

In the present embodiment, the semiconductor layer 31 is formed by epitaxially growing the GaN layer 32, which is an n+ type semiconductor layer, the GaN layer 33, which is an n- type semiconductor layer, and the GaN layer 34, which is an n+ type semiconductor layer, in the layering direction. In the present embodiment, the GaN layer 32 is removed by dry etching, and the shape of the step difference is transferred to the upper surface of the GaN layer 33, which is the n- type semiconductor layer. According to the present embodiment, the semiconductor element 1 including the GaN layer 33 in which a mesa structure or a trench structure is formed, the GaN layer 33, which is the n- type semiconductor layer, can be manufactured.

The embodiment disclosed by the present application can be modified without departing from the main point or the scope of the present invention. The embodiment disclosed by the present application and variations thereof can be combined as appropriate.

The characteristic embodiment has been described in order to fully and clearly disclose the technology according to the appended claims. However, the appended claims are not to be limited to the embodiment described above, and should be configured to embody all variations and alternative configurations that those skilled in the art may make within the underlying matter set forth herein.

### REFERENCE SIGNS

1 Semiconductor element
2 Semiconductor device
11 Substrate
11a Surface
21 Mask
21a Surface
22 Opening
23 Step difference
31 Semiconductor layer
31b Back surface
32 GaN layer
33 GaN layer
34 GaN layer
41 Schottky metal film
42 Insulating film
43 Upper surface electrode metal film
51 Support substrate
61 Back surface electrode
200 Mounting substrate
201 Electrode pad
202 Electrode pad

## Claims

1. A manufacturing method for a semiconductor element, comprising:
providing a mask comprising an opening on a surface of a substrate while leaving a step difference in the mask at an upper surface region around the opening;
epitaxially growing a semiconductor from the surface exposed through the opening to over the upper surface region around the opening, to produce a semiconductor element comprising a semiconductor layer, the semiconductor layer comprising a first surface to which the step difference is transferred; and
dry-etching the first surface of the semiconductor layer to transfer the step difference, the first surface being a contact surface with the mask before the dry etching is performed, wherein
the mask comprises an element that serves as a donor or an acceptor in the semiconductor layer.

2. The manufacturing method for a semiconductor element, according to claim 1, wherein a mesa structure or a trench structure is formed in the semiconductor element by transferring the step difference.

3. The manufacturing method for a semiconductor element, according to claim 1 or 2, wherein the first surface of the semiconductor layer is dry-etched without a mask.

4. The manufacturing method for a semiconductor element, according to any one of claims 1 to 3, wherein the first surface of the semiconductor layer is dry-etched and then wet-etched.

5. The manufacturing method for a semiconductor element, according to any one of claims 1 to 3, wherein the first surface of the semiconductor layer is dry-etched and then further dry-etched.

6. The manufacturing method for a semiconductor element, according to any one of claims 1 to 5, wherein the semiconductor layer is formed by epitaxially growing an n+ type semiconductor layer, an n- type semiconductor layer, and an n+ type semiconductor layer from the surface in a layering direction.

7. A semiconductor device comprising:
a semiconductor element manufactured by the manufacturing method for a semiconductor element according to any one of claims 1 to 6.
